# EUROPEAN PATENT SPECIFICATION

(11) **EP 0 494 783 B1**
(45) Date of publication and mention of the grant of the patent: **14.06.1995**
(21) Application number: 92300191.1
(22) Date of filing: 09.01.1992
(51) Int. Cl.: H01L 21/00, F27D 9/00

(54) **Furnace structure of semiconductor manufacturing apparatus**
Ofenstruktur einer Herstellungsvorrichtung für Halbleiter
Structure de four d'un dispositif pour la fabrication de semi-conducteurs

(30) Priority: 10.01.1991 JP 1365/91
(43) Date of publication of application: 15.07.1992
(73) Proprietor: NEC CORPORATION, Tokyo (JP)
(72) Inventor: Kawase, Yasuyoshi, c/o NEC Corporation, Minato-ku, Tokyo 108-01 (JP)
(74) Representative: Abnett, Richard Charles

(56) References cited:
- EP-A- 0 187 249
- EP-A- 0 206 180
- US-A- 4 962 726
- IBM TECHNICAL DISCLOSURE BULLETIN, vol. 32, no. 3B, August 1989, New York, US, pp. 302-303 ; 'Hot process tube'
- PATENT ABSTRACTS OF JAPAN, vol. 7, no. 65 (E-165)(1210) 18 March 1983 ; & JP-A-57 211 729

## Description

### Background of the Invention

The present invention relates to a semiconductor manufacturing apparatus and, more particularly, to a diffusion furnace or a vapor phase growth furnace.

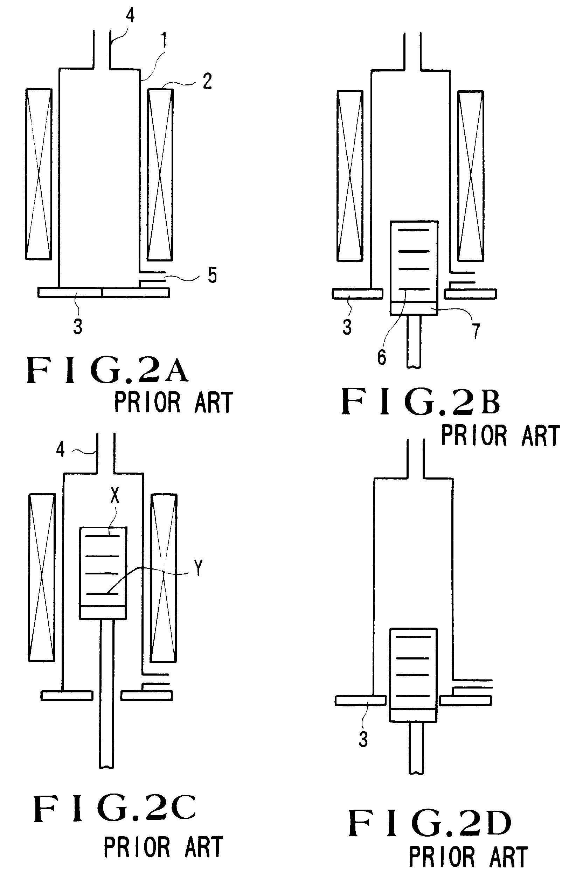

Figs. 2A to 2D illustrate a sequence of operations of a conventional diffusion furnace or vapor phase growth furnace. This furnace comprises a cap-like core tube 1, a heater 2 arranged around the outer surface of the core tube 1, a shutter 3 which is formed at the lower end opening of the core tube 1 and is opened/closed when semiconductor substrates 6 are loaded/unloaded, a gas introduction portion 4 which is connected to the upper central portion of the core tube 1, and an exhaust portion 5 which is connected to the lower inner side wall of the core tube 1 and designed to exhaust gas after reaction (Fig. 2A). When the semiconductor substrates 6 are to be subjected to annealing or a thin-film formation process, the shutter 3 is opened, and a boat 7 having the semiconductor substrates 6 mounted thereon is loaded into the core tube 1 (Fig. 2B). If necessary, a reaction gas is then introduced through the gas introduction portion 4 for annealing the substrates 6 (Fig. 2C). Thereafter, the shutter 3 is opened (Fig. 2D) to unload the semiconductor substrates 6 from the core tube 1.

In the conventional diffusion furnace or vapor phase growth furnace, semiconductor wafers located at upper and lower portions X and Y on the boat 7 in the core tube 1 can have different thermal hysteresis, since the semiconductor substrates 6 are loaded and unloaded through the same opening by means of the shutter 3. In addition, since atmospheric air flows. into the furnace when the shutter 3 is opened, uniformity in film thickness among the respective semiconductor substrates can be degraded.

A similar furnace is described in US patent no. 4962726, on which the claims of this application are based. This document describes a furnace structure having a CVD reaction chamber positioned above a buffer chamber and separated therefrom by an openable shutter. Loading and unloading chambers are provided an opposite sides of the buffer chamber. In operation, a boat positioned in the buffer chamber is loaded with semiconductor wafers from a stack in the loading chamber by a transfer arm. The boat is raised and lowered in the buffer chamber by a boat elevator to allow loading. When the boat is loaded, it is raised into the reaction chamber and, after processing, it is lowered back into the buffer chamber and the wafers unloaded by a second transfer arm into the unloading chamber.

The furnace of US 4962726 suffers the same disadvantage as the conventional furnace described above: because the boat enters and exits the reaction chamber at its lower end, wafers located at upper and lower ends of the boat experience different thermal hysteresis.

A further known furnace is described in European patent application No. 85115144.9, published as EP 0 187249 A. This describes an apparatus in which semiconductor wafers are transported horizontally on a conveyor belt through a series of processing chambers for executing a series of manufacturing steps. One processing chamber is a furnace, which is preceded by a transfer chamber and followed by a rinsing chamber. This enables continuous wafer transfer rather than the batch processing of the known furnaces described above.

### Summary of the Invention

The invention provides a vertical-type furnace structure for a semiconductor manufacturing apparatus, and a method of operating such a furnace structure, as defined in the appendant independent claims, to which reference should now be made. Preferred features of the invention are defined in dependent subclaims.

### Brief Description of the Drawings

Figs. 1A to 1E are views showing a sequence of operations of an embodiment of the present invention; and
Figs. 2A to 2D are views showing a sequence of operations of a conventional semiconductor manufacturing apparatus.

### Description of the Preferred Embodiment

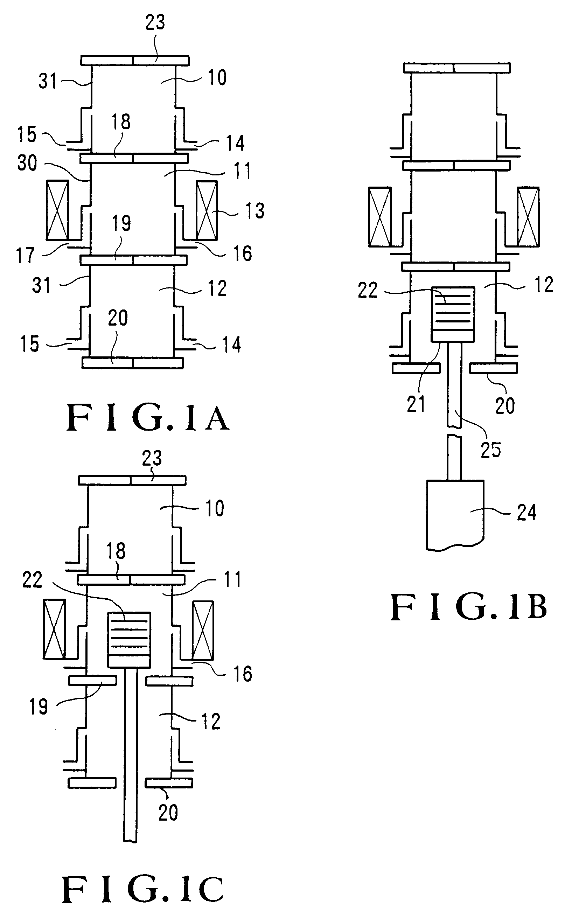

The present invention will be described below with reference to the accompanying drawings. Figs. 1A to 1E illustrate a sequence of operations of an embodiment of the present invention, which is applied to a vertical type diffusion furnace.

The furnace structure of a semiconductor manufacturing apparatus of this embodiment is constituted by a process chamber 11 and preliminary, or outer chambers 10 and 12, as shown in Fig. 1A. The process chamber 11 includes a cylindrical core tube 30, a gas introduction portion 16 and an exhaust portion 17 respectively open to the inner surface of the core tube 30, and a heater 13 arranged around the outer surface of the core tube 30. The preliminary, or second and first outer chambers 10 and 12 respectively communicate with the upper and lower openings of the process chamber 11. Each preliminary chamber includes a core tube 31 having the same shape as that of the process chamber 11 and a gas introduction portion 14 and an exhaust portion 15 respectively open to the inner surface of the core tube 31. The preliminary chamber 10 and the process chamber 11, and the process chamber 11 and the preliminary chamber 12 are respectively separated from each other by second and first inner shutters 18 and 19 at the openings. A first outer shutter 20 serving as an entrance is formed at the lower opening of the preliminary chamber 12, whereas a second outer shutter 23 serving as an exit is formed at the upper opening of the preliminary chamber 10.

A gas such as nitrogen is introduced into the preliminary chambers 10 and 12 and the process chamber 11 through the gas introduction portions 14 and 16. The shutter 20 is then opened, as shown in Fig. 1B, and a rod 25 is moved upward by a boat movement control unit 24 upon interlocking with the operation of the shutter 20. As a result, semiconductor substrates 22 mounted on a boat 21 fixed to the distal end of the rod 25 are loaded in the preliminary chamber 12. Subsequently, the shutter 20 is closed. After this state is maintained for 1 to 10 minutes, the shutter 19 is opened, and the semiconductor substrates 22 are moved into the process chamber 11 by the rod 25, as shown in Fig. 1C. The rod 25 is retracted and the shutter 19 is closed. An annealing or a thin-film formation process as a semiconductor manufacturing process is performed with respect to the semiconductor substrates 22 by using a predetermined reaction gas (if necessary) introduced through the gas introduction portion 16 and the heater 13.

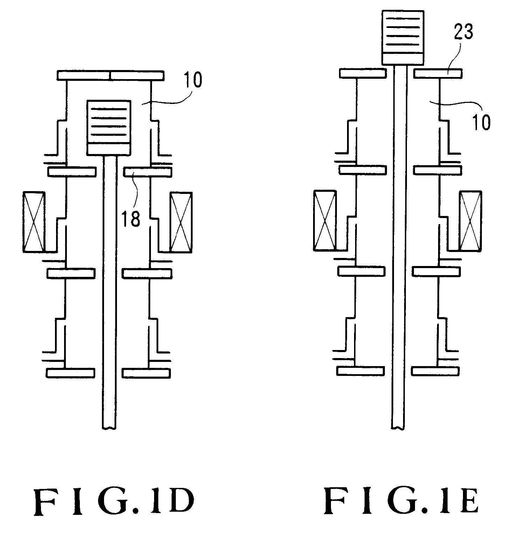

As shown in Fig. 1D, when the annealing or the thin-film formation process is completed, the shutter 18 is opened, and the semiconductor substrates 22 are moved by the rod 25 into the preliminary chamber 10 in which a gas such as nitrogen is introduced. The rod 25 is retracted and the shutter 19 is closed. After the semiconductor substrates 22 are cooled in the preliminary chamber 10, the shutter 23 is opened, and the substrates 22 are unloaded to the outer atmosphere (Fig. 1E).

As has been described above, according to the semiconductor manufacturing apparatus illustrated having a diffusion furnace or a vapor phase growth furnace, since semiconductor substrates are loaded through one opening of the process chamber and unloaded through the other opening, a uniform thermal hysteresis can be realized among the semiconductor substrates located at different mounting positions on a boat (in a batch). In addition, since the preliminary chambers are respectively arranged on the loading and unloading sides of the process chamber, entrance of atmospheric air into the process chamber can be prevented at the time of loading. These can improve uniformity in film thickness among semiconductor substrates so that the variation in thickness is 1/5 or less than that obtained by the conventional apparatus.

## Claims

1. A vertical-type furnace structure for a semiconductor manufacturing apparatus, comprising;
a process chamber (11) for performing a predetermined semiconductor manufacturing process;
a first outer chamber (12) positioned below the process chamber and communicating therewith by means of an opening in a lower wall of the process chamber, a first inner shutter (19) being positioned to open and close the opening; and
a boat (21) for carrying semiconductor substrates in the furnace structure, characterised by;
a second outer chamber (10) positioned above the process chamber and communicating therewith by means of an opening in an upper wall of the process chamber, a second inner shutter (18) being positioned to open and close the opening;
first and second outer shutters (20), (23) positioned to open and close loading and unloading openings formed in a lower wall of the first outer chamber and an upper wall of the second outer chamber respectively; and,
a boat movement control means (25) which moves the boat sequentially through the first outer chamber, the process chamber and the second outer chamber;
the first outer chamber, the process chamber and the second outer chamber each comprising a cylindrical core tube (30, 31), the tubes being arranged in series.

2. A structure according to claim 1, wherein the process chamber core tube (30) has a gas introduction portion (16) and a gas exhaust portion (17) formed in a circumferential surface thereof, and a heater (13) is arranged around an outer surface of the process chamber core tube.

3. A structure according to claim 1 or 2, wherein each outer chamber core tube (31) comprises a gas introduction portion (14) and a gas exhaust portion (15) formed in a circumferential surface thereof.

4. A method of performing a predetermined semiconductor manufacturing process in a vertical-type furnace structure according to claim 1,
the method comprising the steps of;
controlling the boat movement control means to hold the boat and substrates in the first outer chamber after the substrates enter the furnace structure through the entrance opening;
controlling the boat movement control means to load the boat into the process chamber and carrying out the manufacturing process on the semiconductor substrates in the process chamber; and
controlling the boat movement control means to unload the boat into the second outer chamber and hold it there prior to removing the substrates from the furnace structure through the exit opening;
the shutters being opened and closed as required to allow passage of the boat.

5. A method according to claim 4, in which the manufacturing process is a heat treatment.

6. A method according to claim 4, in which the manufacturing process is a thin-film formation process.

## Patentansprüche

1. Senkrechter Ofenaufbau für eine Herstellungsvorrichtung für Halbleiter mit:
einer Prozeßkammer (11) zum Durchführen eines vorbestimmten Herstellungsprozesses für Halbleiter;
einer ersten Außenkammer (12), die unter der Prozeßkammer angeordnet ist und mit ihr über eine Öffnung in einer unteren Wand der Prozeßkammer in Verbindung steht, wobei ein erster Innenverschluß (19) zum Öffnen und Schließen der Öffnung angeordnet ist; und
einem Boot (21) zum Überführen von Halbleitersubstraten in den Ofenaufbau, gekennzeichnet durch:
eine zweite Außenkammer (10), die über der Prozeßkammer angeordnet ist und mit ihr über eine Öffnung in einer oberen Wand der Prozeßkammer in Verbindung steht, wobei ein zweiter Innenverschluß (18) zum Öffnen und Schließen der Öffnung angeordnet ist;
einen ersten (20) und zweiten Außenverschluß (23), die so angeordnet sind, daß sie eine Be- und Entladeöffnung öffnen und schließen, die in einer unteren Wand der ersten Außenkammer bzw. einer oberen Wand der zweiten Außenkammer ausgebildet sind; und
eine Steuereinrichtung (25) für die Bootsbewegung, die das Boot nacheinander durch die erste Außenkammer, die Prozeßkammer und die zweite Außenkammer bewegt;
wobei die erste Außenkammer, die Prozeßkammer und die zweite Außenkammer jeweils ein zylindrisches Kernrohr (30, 31) aufweisen und die Rohre in Reihe angeordnet sind.

2. Aufbau nach Anspruch 1, wobei das Kernrohr (30) der Prozeßkammer einen Gaseinlaßabschnitt (16) und einen Gasauslaßabschnitt (17) hat, die in einer Umfangsfläche von ihm ausgebildet sind, und ein Heizer (13) um eine Außenfläche des Kernrohrs der Prozeßkammer angeordnet ist.

3. Aufbau nach Anspruch 1 oder 2, wobei jedes Kernrohr (31) der Außenkammern einen Gaseinlaßabschnitt (14) und einen Gasauslaßabschnitt (15) aufweist, die in einer Umfangsfläche von ihnen ausgebildet sind.

4. Verfahren zum Durchführen eines vorbestimmten Herstellungsprozesses für Halbleiter in einem senkrechten Ofenaufbau nach Anspruch 1, wobei das Verfahren die folgenden Schritte aufweist:
Steuern der Steuereinrichtung für die Bootsbewegung, um das Boot und Substrate in der ersten Außenkammer zu halten, nachdem die Substrate in den Ofenaufbau durch die Eingangsöffnung eintreten;
Steuern der Steuereinrichtung für die Bootsbewegung, um das Boot in die Verfahrenskammer zu laden, und Durchführen des Herstellungsprozesses an den Halbleitersubstraten in der Verfahrenskammer; und
Steuern der Steuereinrichtung für die Bootsbewegung, um das Boot in die zweite Außenkammer zu entladen und es dort zu halten, bevor die Substrate aus dem Ofenaufbau durch die Ausgangsöffnung entfernt werden;
wobei die Verschlüsse bedarfsgemäß geöffnet und geschlossen werden, damit das Boot passieren kann.

5. Verfahren nach Anspruch 4, wobei der Herstellungsprozeß eine Wärmebehandlung ist.

6. Verfahren nach Anspruch 4, wobei der Herstellungsprozeß ein Prozeß zur Dünnfilmausbildung ist.

## Revendications

1. Structure de four du type vertical pour un dispositif de fabrication de semi-conducteurs, comprenant :
une chambre de traitement (11) pour exécuter un procédé de fabrication de semi-conducteurs prédéterminé;
une première chambre extérieure (12) placée au-dessous de la chambre de traitement et communiquant avec elle au moyen d'une ouverture ménagée dans une paroi inférieure de la chambre de traitement, un premier volet intérieur (19) étant placé de manière à ouvrir et fermer l'ouverture; et
une nacelle (21) pour acheminer des substrats de semi-conducteurs dans la structure du four, caractérisée par :
une seconde chambre extérieure (10) placée au-dessus de la chambre de traitement et communiquant avec elle au moyen d'une ouverture pratiquée dans une paroi supérieure de la chambre de traitement, un second volet intérieur (18) étant placé de façon à ouvrir et fermer l'ouverture;
des premier et second volets extérieurs (20, 23) placés de façon à ouvrir et fermer des ouvertures de chargement et de déchargement formées dans la paroi inférieure de la première chambre extérieure et la paroi supérieure de la seconde chambre extérieure, respectivement; et
un moyen (25) de commande du mouvement de la nacelle sui déplace la nacelle séquentiellement à travers la première chambre extérieure, la chambre de traitement et la seconde chambre extérieure,
la première chambre extérieure, la chambre de traitement et la seconde chambre extérieure comprenant chacune un tube cylindrique de coeur (30, 31), les tubes étant disposés en série.

2. Structure selon la revendication 1, dans laquelle le tube (30) du coeur de la chambre de traitement a une partie d'introduction de gaz (16) et une partie d'évacuation de gaz (17) formées dans sa surface circonférentielle, et un élément chauffant (13) est disposé autour d'une surface extérieure du tube du coeur de la chambre de traitement.

3. Structure selon la revendication 1 ou 2, dans laquelle le tube de coeur (30) de chaque chambre extérieure comprend une partie d'introduction de gaz (14) et une partie d'évacuation de gaz (15) formées dans sa surface circonférentielle.

4. Procédé d'exécution d'un procédé de fabrication prédéterminé de semi-conducteurs dans une structure de four du type vertical selon la revendication 1,
le procédé comprenant les étapes consistant à :
commander le moyen de commande du mouvement de la nacelle de manière à maintenir la nacelle et les substrats dans la première chambre extérieure après que les substrats soient entrés dans la structure du four par l'intermédiaire de l'ouverture d'entrée;
commander le moyen de commande du mouvement de la nacelle afin de charger la nacelle dans la chambre de traitement et exécuter le procédé de fabrication sur les substrats de semi-conducteurs dans la chambre de traitement; et
commander le moyen de commande du mouvement de la nacelle de manière à décharger la nacelle dans la seconde chambre et l'y maintenir avant d'enlever les substrats de la structure du four par l'intermédiaire de l'ouverture de sortie;
les volets étant ouverts et fermés selon nécessité pour permettre le passage de la nacelle.

5. Procédé selon la revendication 4, dans lequel le procédé de fabrication est un traitement thermique.

6. procédé selon la revendication 4, dans lequel le procédé de fabrication est un procédé de formation de film fin.
